# FASCICULE DE BREVET EUROPEEN

(11) **EP 3 729 925 B1**
(45) Date de publication et mention de la délivrance du brevet: **09.03.2022**
(21) Numéro de dépôt: 18807637.6
(22) Date de dépôt: 28.11.2018
(51) Int. Cl.: H02K 11/33, H05K 7/20

(54) **ELECTRONIQUE DE PUISSANCE CIRCULAIRE OU TOROIDALE REFROIDIE PAR UN FLUX**
STRÖMUNGSGEKÜHLTE TOROID- ODER RUNDLEISTUNGSELEKTRONIK
FLOW-COOLED TOROIDAL OR CIRCULAR POWER ELECTRONICS

(30) Priorité: 18.12.2017 FR 1762370
(43) Date de publication de la demande: 28.10.2020
(73) Titulaire: IFP Energies nouvelles, 92852 Rueil-Malmaison (FR)
(72) Inventeur: BATTISTON, Alexandre, 92500 RUEIL-MALMAISON (FR); KEFSI, Laid, 92380 GARCHES (FR); LE BERR, Fabrice, 92500 RUEIL MALMAISON (FR)
(74) Mandataire: IFP Energies nouvelles
(86) Numéro de dépôt international: PCT/EP2018/082883
(87) Numéro de publication internationale: WO 2019/120914

(56) Documents cités:
- EP-A1- 3 177 115
- WO-A1-2015/170036
- WO-A1-2016/012666
- US-A- 5 235 491
- US-A- 5 491 370
- US-A1- 2002 170 905

## Description

La présente invention se rapporte au domaine des systèmes électroniques de puissance pour contrôler des machines électriques comme notamment des systèmes de suralimentation utilisés par exemple pour des moteurs à combustion interne. Plus spécifiquement, l'invention concerne un système électronique de puissance configuré pour être refroidi par un dispositif de refroidissement.

Certains systèmes électroniques de puissance peuvent être des convertisseurs électroniques de puissance DC/AC (courant continu et alternatif), notamment des onduleurs, qui ont pour fonction d'interfacer des sources de tension continues avec des machines électriques alternatives. Ces onduleurs permettent de réaliser différentes fonctions essentielles pour la conversion et la mise en forme des grandeurs électriques (courants, tensions et fréquence) issues des sources de tension continues. Ainsi, les fonctions réalisées par ces onduleurs sont notamment d'interfacer une source de tension avec une charge ou une source de nature différente, d'assurer le contrôle des tensions et courants mis en jeu, d'assurer une bonne qualité d'énergie, que ce soit du côté des sources ou du côté des charges et d'assurer la stabilité électrique de l'ensemble du système de conversion.

Généralement, comme les systèmes électroniques de puissance comprennent des composants électroniques de puissance, ces systèmes vont générer de la chaleur. La chaleur générée peut amener les composants de puissance à des températures telles, que les performances des composants de puissance peuvent être dégradées, voire même leurs structures peuvent être endommagées. Ceci est d'autant plus vrai dans les environnements thermiquement contraignants comme c'est le cas pour un moteur à combustion interne.

Pour pallier à ces problèmes de montée en température, différentes solutions ont été développées. Ainsi le document US 6930417 B2 décrit un onduleur combiné à un moteur électrique dans lequel les composants de puissance de l'onduleur sont montés directement sur le moteur électrique. Dans ce cas de figure, les composants de puissance de l'onduleur sont refroidis par un circuit de refroidissement à eau ou liquide.

Le document US005491370A décrit l'intégration d'une électronique de puissance au plus proche d'une machine électrique. Les composants de puissances sont disposés sur le contour de la carcasse de la machine électrique. Cette structure utilise de la même manière un circuit de refroidissement à eau.

D'autres solutions enfin proposent d'utiliser un ventilateur afin de refroidir les composants électroniques de puissance.

Des exemples de systèmes électroniques de puissance sont présentés dans les documents WO 2015/170036, EP 3 177 115, WO 2016/012666, US 5 235 491 et US 2002/170905.

Ces structures de l'art antérieur présentent plusieurs inconvénients comme notamment le besoin de systèmes de refroidissement lourds à concevoir et à intégrer tels que des circuits de refroidissement à eau ou des ventilateurs, ou encore comme le besoin d'utiliser des composants de puissances qui aient une haute tenue aux températures élevées dès lors que ceux-ci sont disposés à proximité d'un moteur à combustion interne. Ceci nécessite alors un surcout pour les systèmes électroniques de puissance.

La présente invention vise ainsi à remédier aux inconvénients énumérés ci-dessus et vise à proposer une solution pour refroidir les systèmes électroniques de puissance qui soit simple à concevoir et efficace, tout en intégrant au plus proche de la machine électrique à piloter les composants électroniques de manière à limiter aussi bien les couts de conception et d'utilisation de matériaux servant au câblage entre les composants et la machine que les couts des composants de puissances.

Ainsi, pour atteindre au moins les objectifs susvisés, parmi d'autres, la présente invention propose, selon un premier aspect, un système électronique de puissance comprenant un ou plusieurs composants électroniques de puissance implémentés au moins en partie sur une ou plusieurs cartes électroniques caractérisé en ce que ladite carte électronique a une forme circulaire ou toroïdale plane comprenant au centre une ouverture circulaire de diamètre D pour coopérer avec une durite de circulation d'un flux.

L'effet d'une telle configuration va être de pouvoir utiliser le flux d'une durite pour refroidir des composants électroniques de puissance. Les composants, étant placés sur les cartes, vont pouvoir bénéficier de l'évacuation de la chaleur par le flux. Cela permet en outre d'utiliser un système de durite existant et d'adapter simplement le système électronique de puissance à un dispositif comprenant une durite déjà existant et cela sans modifier le système déjà existant et cela permet d'avoir un système électronique de puissance peu encombrant et simple à mettre en œuvre.

Selon l'invention, la carte électronique est positionnée sensiblement orthogonalement à la durite de circulation du flux et sensiblement dans le même axe que ladite durite de manière à ce que ledit flux circule à travers l'ouverture circulaire de la carte électronique.

L'effet est d'avoir le maximum de flux qui circule à travers l'ouverture, dans un but d'avoir une évacuation de chaleur maximale.

Selon l'invention, ladite durite de circulation du flux est une durite d'admission d'air d'un moteur à combustion interne. De cette manière on peut utiliser l'air d'admission dans un moteur pour le faire transiter au centre du dispositif électronique. Cet aire étant à température ambiante, il permet d'évacuer de la chaleur d'un source de chaleur supérieure.

Selon l'invention, la durite a un diamètre D1 sensiblement supérieur ou égal au diamètre D de l' ouverture circulaire de la carte électronique. De cette manière tout le flux circulant à travers la durite sera utilisé pour l'évacuation de chaleur.

Selon l'invention, le système électronique de puissance comprend un boitier mécanique dans lequel est montée la carte électronique. Un tel boitier permet de maintenir les cartes entre elles mais aussi de les protéger des sollicitations extérieures.

Selon l'invention, le boitier mécanique est de forme circulaire ou toroïdale et comprend une ouverture centrale de diamètre D2 sensiblement équivalent ou supérieur au diamètre D de l'ouverture circulaire de la carte électronique. L'effet est de permettre au flux circulant à travers le dispositif de ne pas être entravé par les bords du boitier et de pouvoir circuler entièrement au centre du dispositif électronique.

Selon l'invention, le boitier mécanique intègre des ailettes destinées à capter la chaleur à l'intérieur du boitier mécanique et à la transférer au flux de la durite. De telles ailettes jouent le rôle d'un radiateur et permet un transfert de la chaleur qui s'accumule dans le boitier vers le flux de la durite qui permet d'évacuer la dite chaleur.

Selon l'invention, le boitier mécanique intègre un ventilateur. L'intérêt d'un tel ventilateur est d'optimiser les transferts et donc l'évacuation de chaleur dans le flux. Il vient en complément des ailettes.

Selon l'invention, le boitier mécanique comprend un système de circulation d'une partie du flux de la durite à l'intérieur dudit boitier mécanique. L'effet est d'améliorer et d'accélérer les transferts et évacuation de la chaleur.

Selon l'invention, le système électronique de puissance comprend un dissipateur thermique connecté thermiquement à la carte électronique et/ou aux composants électroniques de puissance. Un tel dissipateur a pour effet d'augmenter la surface d'échange thermique et donc de favoriser et d'accélérer l'évacuation de chaleur.

Selon l'invention, le dissipateur thermique est un cylindre de diamètre D3 sensiblement équivalent au diamètre de la carte électronique et ledit dissipateur thermique comprend une ouverture centrale de diamètre sensiblement équivalent au diamètre D de l'ouverture circulaire de la carte électronique et l'ouverture centrale comprend un bord interne. L'effet est de pouvoir positionner ce dissipateur dans le flux de la durite pour obtenir le maximum de surface d'échange thermique mais aussi d'interférer le minimum avec la circulation du flux dans la durite. Ce dissipateur est également optimisé pour être au plus près des composants électroniques pour une récupération rapide la chaleur produite.

Selon l'invention, le dissipateur thermique comprend des ailettes positionnées circulairement sur le bord interne et les ailettes convergent du bord interne du dissipateur thermique vers le centre de la durite. L'effet des ailettes est d'augmenter la surface d'échange thermique avec le flux.

Selon l'invention, le cylindre comprend des dents. L'effet des dents est également d'augmenter la surface d'échange thermique avec le flux.

Selon l'invention, le dissipateur thermique est un cylindre de diamètre extérieur D4 qui comprend une ouverture centrale de diamètre sensiblement équivalent au diamètre D de l' ouverture circulaire de la carte électronique et l'ouverture centrale comprend un bord interne. Cette configuration du dissipateur permet de la positionner dans le flux et d'avoir une surface augmentée d'échange thermique avec le flux.

Selon l'invention, les composants électroniques de puissance sont implémentés au moins en partie sur le cylindre. De cette manière la chaleur est directement transmise au dissipateur qui permet de l'évacuer rapidement grâce au flux.

Selon l'invention, le dissipateur thermique comprend des ailettes positionnées circulairement sur le bord interne et les ailettes convergent du bord interne du dissipateur thermique vers le centre de la durite. L'effet des ailettes est d'augmenter la surface d'échange thermique avec le flux et d'apporter la chaleur au plus proche du centre là ou l'évacuation de la chaleur est optimale.

Selon l'invention, le système électronique de puissance alimente une machine électrique. De cette manière on peut avoir une machine électrique pilotée par un système compact.

Selon l'invention, ladite machine électrique entraîne un compresseur.

Selon l'invention, ladite machine électrique entraîne une turbine d'un turbocompresseur.

Selon l'invention, ladite machine électrique est disposée en amont dudit compresseur ou de la turbine dudit turbocompresseur.

Selon l'invention, ladite machine électrique est disposée sur un arbre qui relie le compresseur dudit turbocompresseur à une turbine dudit turbocompresseur.

Selon un second aspect, l'invention concerne un dispositif de refroidissement d'un système électronique de puissance tel que décrit précédemment et caractérisé en ce qu'il comprend un dissipateur thermique tel que décrit précédemment et intégré dans l'axe d'une durite de circulation d'un flux.

### Présentation succincte des figures

D'autres caractéristiques et avantages du dispositif selon l'invention, apparaîtront à la lecture de la description ci-après d'exemples non limitatifs de réalisation, en se référant aux figures annexées et décrites ci-après.
La figure 1a est une vue de face d'un système électronique de puissance dans un premier mode de réalisation ;
La figure 1b est une vue en perspective d'un système électronique de puissance dans le premier mode de réalisation ;
La figure 1c est une vue en coupe de profil d'une machine électrique et d'un système électronique de puissance dans le premier mode de réalisation ;
La figure 2a est une vue de face d'un système électronique de puissance dans un deuxième mode de réalisation ;
La figure 2b est une vue en perspective d'un système électronique de puissance dans le deuxième mode de réalisation ;
La figure 2c est une vue en coupe de profil d'une machine électrique et d'un système électronique de puissance dans le deuxième mode de réalisation ;
La figure 3 illustre un dispositif selon une première configuration dans le cas d'un turbocompresseur entraîné par une machine électrique ;
La figure 4 illustre un dispositif selon une deuxième configuration dans le cas d'un turbocompresseur entraîné par une machine électrique ;
La figure 5 illustre un dispositif selon une troisième configuration dans le cas d'un turbocompresseur entraîné par une machine électrique ;
La figure 6 illustre un dispositif intégré dans le cas d'un compresseur.

### Description détaillée de l'invention

L'invention proposée consiste en une électronique de puissance (1) pour électrifier des machines électriques (ME) que l'on peut retrouver dans des groupes motopropulseurs comprenant un moteur (M) notamment à combustion interne. Ces machines électriques (ME) peuvent servir par exemple pour la suralimentation de moteurs à combustion interne et peuvent être, de manière non limitative, des compresseurs (C) ou des turbocompresseurs (Tc) entraînés par une machine électrique. Cette électronique de puissance (1) peut comprendre une ou plusieurs cartes électroniques (3), sur lesquelles sont montées des composants électroniques. Dans le cas où le système électronique de puissance (1) est un onduleur, servant à interfacer une source de courant avec une machine électrique (ME), le système électronique de puissance (1) peut comprendre des composants électroniques (2) de puissance. Ces composants électroniques (2) de puissance sont intégrés sur une des cartes électroniques (3). Les cartes électroniques (3) peuvent être intégrées dans un boitier mécanique (6). Dans le cadre de l'invention, les composants électroniques (2) de puissance sont refroidis par un flux qui circule dans une durite (5) de circulation d'un flux. Dans le cas d'un moteur (M) à combustion interne, cette durite (5) est une durite (5) d'admission de l'air du moteur (M). La température de l'air admis dans cette durite (5) est généralement proche de la température de l'air ambiante (autour de 20°C dans les conditions nominales). De plus, le débit d'air admis dans la durite (5) est généralement proportionnel à la puissance demandée au moteur (M). Comme cela sera décrit par la suite, l'invention concerne un dispositif de refroidissement qui utilise le flux de la durite (5) de circulation de ce flux pour refroidir les composants électroniques.

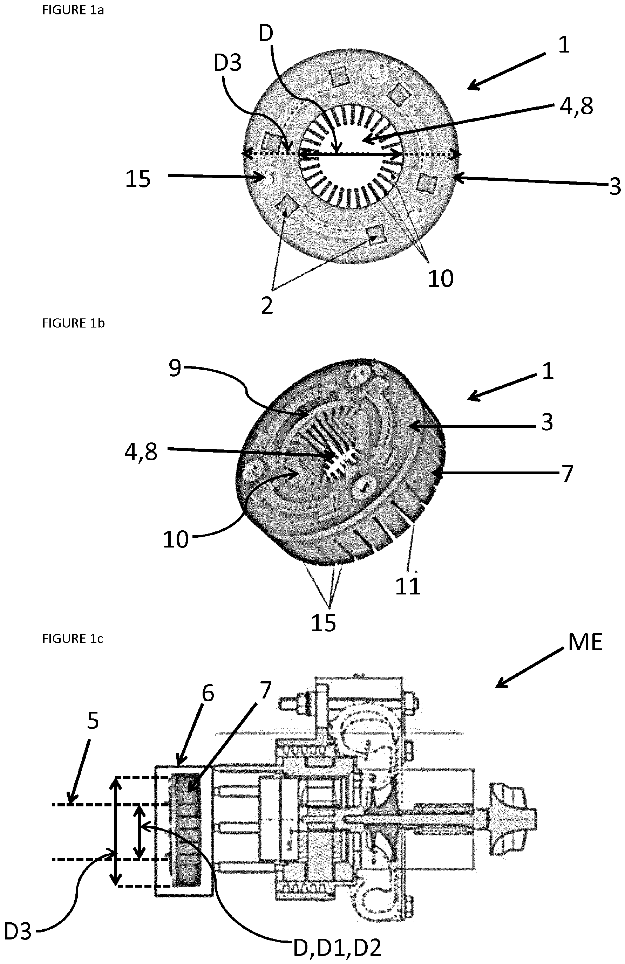

Dans un premier mode de réalisation du système électronique de puissance (1) visible sur les figures 1a à 1c, le système électronique de puissance (1) comprend un ou plusieurs composants électroniques (2) de puissance. Ces composants électroniques (2) de puissance sont implémentés sur une carte électronique (3) destinée à recevoir l'ensemble des composants électroniques (2) de puissance ainsi que l'ensemble des autre composants électroniques. Sans sortir du cadre de l'invention il peut y avoir plusieurs cartes électroniques (3) où une seule intègre l'ensemble des composants électroniques (2) de puissance ou alors ceux-ci sont répartis sur plusieurs des cartes électroniques (3) embarquées. Comme visible à la figure 1a, les cartes électroniques (3) ont une forme circulaire ou toroïdale plane comprenant au centre une ouverture circulaire (4) de diamètre D.

Dans ce premier mode de réalisation et comme visible sur la figure 1c, les cartes électroniques (3) sont positionnées sensiblement orthogonalement à la durite (5) de circulation du flux et sensiblement dans le même axe que ladite durite (5) de manière à ce que le flux circule à travers les ouvertures circulaires (4) des cartes électroniques (3). D'une manière générale, la durite (5) de circulation du flux est une durite (5) d'admission d'air d'un moteur (M) à combustion interne. Le diamètre de la durite (5) est égal à un diamètre D1 et ce diamètre D1 est sensiblement supérieur ou égal au diamètre D des ouvertures circulaires (4) des cartes électroniques (3) de manière à ce que l'ensemble du flux passant dans la durite (5) passe également à travers les ouvertures circulaires (4) des cartes électroniques (3). Comme évoqué précédemment, le système électronique de puissance (1) comprend un boitier mécanique (6) dans lequel sont montées les cartes électroniques (3) dans le cas où il y en a plusieurs. Dans ce cas-là, le boitier mécanique (6) est de forme circulaire ou toroïdale et comprend une ouverture centrale de diamètre D2. Le diamètre D2 de cette ouverture centrale est sensiblement équivalent ou supérieur au diamètre D des ouvertures circulaires (4) des cartes électroniques (3). De cette manière, le boitier mécanique (6) permet un maintien des cartes électroniques (3) dans le flux de la durite (5) tout en n'obstruant pas le débit du flux.

Dans le cadre de l'invention et comme visible sur la figure 1b, le système électronique de puissance (1) va comprendre un dissipateur thermique (7) afin de refroidir les composants électroniques (2) de puissance. Ce dissipateur thermique (7) est connecté thermiquement à la carte électronique (3). Comme visible aux figures 1b et 1c, le dissipateur thermique (7) est un cylindre de diamètre D3. Ce diamètre D3 du cylindre est sensiblement équivalent au diamètre des cartes électroniques (3) afin d'avoir une surface d'échange thermique la plus grande possible. Pour jouer efficacement son rôle de dissipation de chaleur, ce dissipateur thermique (7) comprend une ouverture centrale (8). Cette ouverture centrale (8) a un diamètre sensiblement équivalent au diamètre D des ouvertures circulaires (4) des cartes électroniques (3) toujours dans la perspective de laisser circuler le flux. Le cylindre a une longueur qui peut être définie selon la quantité de chaleur qui est à évacuer, suivant le nombre et la taille des composants électroniques (2) de puissance et l'ouverture centrale (8) dans la longueur du cylindre va définir un bord interne (9) qui aura la longueur du cylindre. Dans ce mode de réalisation, le dissipateur thermique (7) comprend des ailettes (10) positionnées circulairement sur le bord interne (9). Les ailettes (10) convergent du bord interne (9) du dissipateur thermique (7) vers le centre de la durite (5). De cette manière, on obtient un dissipateur qui vient collecter les calories perdues par les composants pour les transférer au centre du cylindre là ou passe le flux, et au plus proche du diamètre interne, directement connecté sur le support sur lequel seront réalisés les ailettes, ce qui permet un refroidissement efficace sans venir trop perturber le flux d'air et le fonctionnement des composants présents en aval.

Comme visible à la figure 1b, le cylindre peut également comprendre des dents (11) qui sont orientées dans le sens du flux. Elles ont pour fonction d'amplifier l'évacuation de la chaleur.

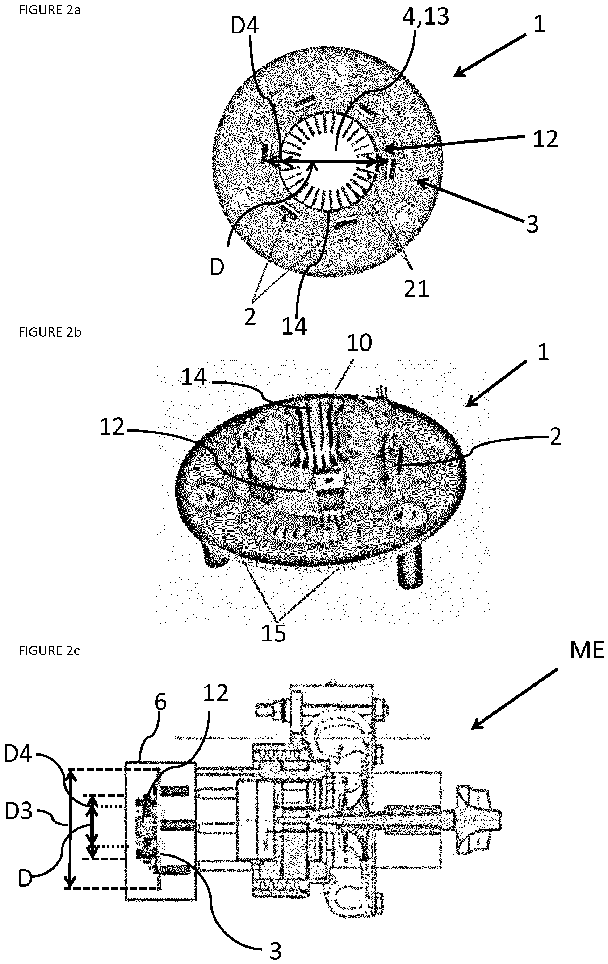

Dans un second mode de réalisation visible aux figures 2a à 2c, le dissipateur thermique (7) est un cylindre (12) de diamètre extérieur D4 qui comprend une ouverture centrale (13) de diamètre sensiblement équivalent au diamètre D des ouvertures circulaires (4) des cartes électroniques (3). L'ouverture centrale (13) comprend un bord interne (14). Le cylindre est connecté thermiquement à la carte électronique (3), et est positionné en amont de celle-ci, c'est-à-dire dans le sens de circulation du flux. Cependant elle peut également être positionnée en aval de la carte électronique. Dans ce deuxième mode de réalisation les composants électroniques (2) de puissance sont implémentés au moins en partie sur le cylindre (12). L'autre partie étant positionnée sur la carte électronique (3). On a ainsi une solution avec des composants de puissance (2) traversant sur le dissipateur thermique (7) associé.

Dans ce deuxième mode de réalisation, le dissipateur thermique (7) peut également comprendre des ailettes (10). Dans ce cas-là elles sont positionnées circulairement sur le bord interne (14) et elles convergent du bord interne (14) du dissipateur thermique (7) vers le centre de la durite (5). De la même manière que dans le premier mode de réalisation, on obtient un dissipateur qui vient collecter les calories perdues par les composants pour les transférer au centre du cylindre là ou passe le flux.

Dans ces différents modes de réalisation, ces dispositifs de refroidissement permettent d'utiliser des composants (2) de puissance qui sont moins coûteux car ceux-ci fonctionnent dans des conditions optimales. De cette manière, on peut réduire le coût du système électronique de puissance (1) tout en garantissant un niveau de performance adéquat. En outre, un intérêt réside dans le fait de pouvoir se passer de dispositif de refroidissement annexes comme cela a été évoqué précédemment, et qui sont notamment soit des ventilateurs dédiés (ce qui limite en outre l'énergie consommée par le système) ou des dispositifs de circulation de liquide de refroidissement, type circuit à eau. Un tel système de refroidissement permet en outre de pouvoir intégrer le système électronique de puissance (1) dans un environnement très proche du moteur (M) à combustion interne avec comme effet bénéfique de réduire la longueur des connections avec la machine électrique (ME) (et donc une réduction des contraintes CEM).

Ce type de solution est particulièrement adéquat pour l'électronique de puissance (1) d'un composant électrifiant des organes de suralimentation, car cela permet de proposer des solutions compactes et intégrées de machines électriques (ME) et onduleur. En effet et dans ce cas précis, l'électronique de puissance (1) peut être positionnée au plus près d'une machine électrique (ME).

Dans les différents modes de réalisation précédent le boitier mécanique (6) peut également intégrer des ailettes supplémentaires (non représentées). Elles ont pour effet de capter la chaleur à l'intérieur du boitier mécanique (6) et de la transférer au flux circulant dans la durite (5).

Le boitier mécanique (6) peut également intégrer un ventilateur (non représenté). Ce ventilateur, contrairement aux ventilateurs dédiés précédemment énoncés, a pour objectif de « brasser » l'air dans le boitier mécanique (6) et ainsi favoriser les échanges thermiques entre les ailettes supplémentaires. Le boitier mécanique (6) peut également comprendre, dans les différents modes de réalisation précédemment énoncés, un système de circulation d'une partie du flux de la durite (5) à l'intérieur dudit boitier mécanique (6). Ceci permet d'augmenter le refroidissement de l'air interne.

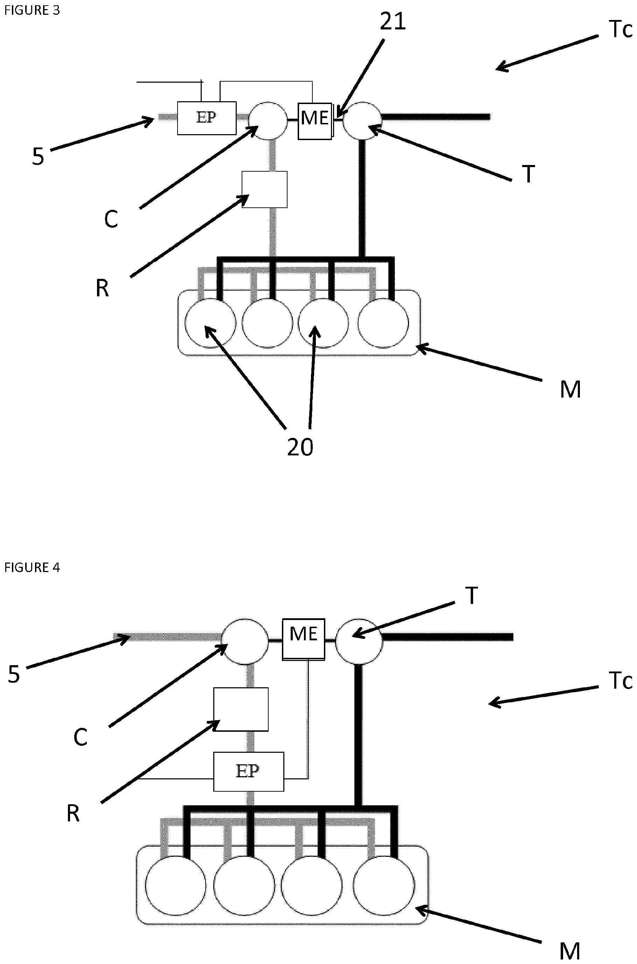

La figure 3 représente un turbocompresseur (Tc) pour un moteur (M) à combustion interne comprenant un ou plusieurs pistons (20). Le turbocompresseur (Tc) comprend un compresseur (C) relié par un arbre (21) à une turbine (T), une machine électrique (ME), une durite (5) d'admission d'air, et un refroidisseur de suralimentation (R). Le système électronique de puissance (1) peut être positionné en amont par exemple du compresseur (C) d'air, là où la température d'air est relativement modérée (< 50°C), permettant de réduire la longueur des câbles entre les deux organes (permettant d'améliorer le rendement et limiter les pertes CEM...). Pour le mode de réalisation illustré, la machine électrique (ME) est placée sur l'arbre (21) qui lie le compresseur (C) et la turbine (T) du turbocompresseur (Tc).

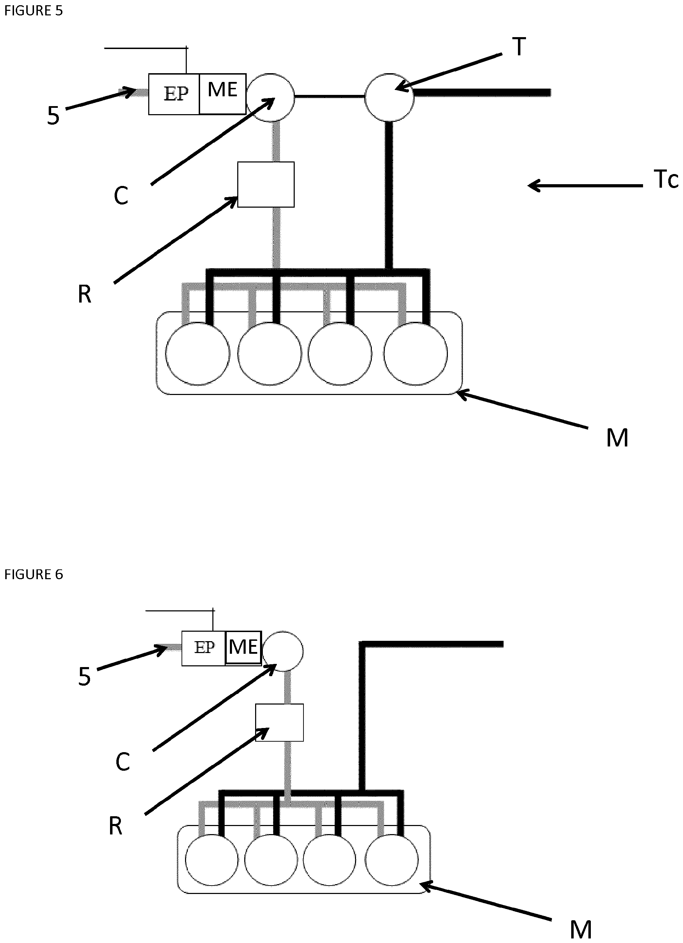

Comme visible sur la figure 4, qui représente le même turbocompresseur (Tc) que la figure 3, l'électronique de puissance (1) peut aussi être positionnée en aval du refroidisseur (R) de suralimentation où la température d'air est contrôlée à une température modérée dans toutes les conditions de fonctionnement. Pour le mode de réalisation illustré, la machine électrique (ME) est placée sur l'arbre (21) qui lie le compresseur (C) et la turbine (T) du turbocompresseur (Tc). Dans le cas où la machine électrique (ME) est positionnée du côté du compresseur (C), cette électronique de puissance (1) peut être intégrée à la machine électrique (ME) pour ne faire qu'un seul et même composant comme visible à la figure 5. Cette configuration permet de réduire au maximum la longueur des câbles entre les deux organes.

La figure 6 représente le cas d'un moteur (M) à combustion interne avec un compresseur (C) dans lequel l'électronique de puissance (1) est intégrée à la machine électrique (ME) pour ne faire qu'un seul et même composant. Cette configuration permet de réduire au maximum la longueur des câbles entre les deux organes.

Dans tous les cas énoncés, cette solution permet en outre de lier mécaniquement l'électronique de puissance (1) au moteur (M) thermique via des flexibles, permettant une filtration et un amortissement des vibrations provenant du moteur thermique.

Dans le cas spécifique d'une machine électrique (ME) traversée par le flux d'air (machine à « air-gap » ou machine « à grille statorique »), il est même possible de joindre les fonctions machine et électronique de puissance (1). Un gain en encombrement, en circuit de refroidissement, et en coût globale du système est réalisé.

Comme il va de soi, l'invention ne se limite pas aux formes de réalisation des systèmes électroniques de puissance (1) et de leur dispositif de refroidissement décrits ci-dessus à titre d'exemple, elle embrasse au contraire toutes les variantes de réalisation.

## Revendications

1. Système électronique de puissance (1) comprenant un ou plusieurs composants électroniques (2) de puissance implémentés au moins en partie sur une ou plusieurs cartes électroniques (3) **caractérisé en ce que** ladite carte électronique (3) a une forme circulaire ou toroïdale plane comprenant au centre une ouverture circulaire (4) de diamètre D pour coopérer avec une durite (5) de circulation d'un flux pour refroidir des composants électroniques de puissance.

2. Système électronique de puissance (1) selon la revendication précédente **caractérisé en ce que** la carte électronique (3) est positionnée sensiblement orthogonalement à la durite (5) de circulation du flux et sensiblement dans le même axe que ladite durite (5) de manière à ce que ledit flux circule à travers l'ouverture circulaire (4) de la carte électronique (3).

3. Système électronique de puissance (1) selon la revendication précédente **caractérisé en ce que** ladite durite (5) de circulation du flux est une durite (5) d'admission d'air d'un moteur (M) à combustion interne.

4. Système électronique de puissance (1) selon la revendication précédente **caractérisé en ce que** la durite (5) a un diamètre D1 sensiblement supérieur ou égal au diamètre D de l' ouverture circulaire (4) de la carte électronique (3).

5. Système électronique de puissance (1) selon l'une des revendications précédentes **caractérisé en ce qu'**il comprend un boitier mécanique (6) dans lequel est montée la carte électronique (3).

6. Système électronique de puissance (1) selon la revendication précédente **caractérisé en ce que** le boitier mécanique (6) est de forme circulaire ou toroïdale et comprend une ouverture centrale de diamètre D2 sensiblement équivalent ou supérieur au diamètre D de l'ouverture circulaire (4) de la carte électronique (3).

7. Système électronique de puissance (1) selon la revendication 5 **caractérisé en ce que** le boitier mécanique (6) intègre des ailettes destinées à capter la chaleur à l'intérieur du boitier mécanique (6) et à la transférer au flux de la durite (5).

8. Système électronique de puissance (1) selon l'une des revendications 5 à 7 **caractérisé en ce que** le boitier mécanique (6) intègre un ventilateur.

9. Système électronique de puissance (1) selon l'une des revendications 5 à 8 **caractérisé en ce que** le boitier mécanique (6) comprend un système de circulation d'une partie du flux de la durite (5) à l'intérieur dudit boitier mécanique (6).

10. Système électronique de puissance (1) selon l'une des revendications précédentes **caractérisé en ce qu'**il comprend un dissipateur thermique (7) connecté thermiquement à la carte électronique (3) et/ou aux composants électroniques (2) de puissance.

11. Système électronique de puissance (1) selon la revendication précédente **caractérisé en ce que** le dissipateur thermique (7) est un cylindre de diamètre D3 sensiblement équivalent au diamètre de la carte électronique (3) et ledit dissipateur thermique (7) comprend une ouverture centrale (8) de diamètre sensiblement équivalent au diamètre D de l'ouverture circulaire (4) de la carte électronique (3) et l'ouverture centrale (8) comprend un bord interne (9).

12. Système électronique de puissance (1) selon la revendication précédente **caractérisé en ce que** le dissipateur thermique (7) comprend des ailettes (10) positionnées circulairement sur le bord interne (9) et les ailettes (10) convergent du bord interne (9) du dissipateur thermique (7) vers le centre de la durite (5).

13. Système électronique de puissance (1) selon la revendication 11 ou 12 **caractérisé en ce que** le cylindre comprend des dents (11).

14. Système électronique de puissance (1) selon la revendication 10 **caractérisé en ce que** le dissipateur thermique (7) est un cylindre (12) de diamètre extérieur D4 qui comprend une ouverture centrale (13) de diamètre sensiblement équivalent au diamètre D de l' ouverture circulaire (4) de la carte électronique (3) et l'ouverture centrale (13) comprend un bord interne (14).

15. Système électronique de puissance (1) selon la revendication précédente **caractérisé en ce que** les composants électroniques (2) de puissance sont implémentés au moins en partie sur le cylindre (12).

16. Système électronique de puissance (1) selon la revendication précédente **caractérisé en ce que** le dissipateur thermique (7) comprend des ailettes (10) positionnées circulairement sur le bord interne (14) et les ailettes (10) convergent du bord interne (14) du dissipateur thermique (7) vers le centre de la durite (5).

17. Système électronique de puissance (1) selon l'une des revendications précédentes **caractérisé en ce qu'**il alimente une machine électrique (ME).

18. Système électronique de puissance (1) selon la revendication précédente **caractérisé en ce que** ladite machine électrique (ME) entraîne un compresseur (C).

19. Système électronique de puissance (1) selon la revendication 17 **caractérisé en ce que** ladite machine électrique (ME) entraîne une turbine (T) d'un turbocompresseur (Tc).

20. Système électronique de puissance (1) selon l'une des revendications 18 ou 19, **caractérisé en ce que** ladite machine électrique (ME) est disposée en amont dudit compresseur (C) ou de la turbine (T) dudit turbocompresseur (Tc).

21. Système électronique de puissance (1) selon la revendication 17, **caractérisé en ce que** ladite machine électrique (ME) est disposée sur un arbre (21) qui relie le compresseur (C) dudit turbocompresseur (Tc) à une turbine (T) dudit turbocompresseur (Tc).

22. Dispositif de refroidissement d'un système électronique de puissance (1) selon l'une des revendications précédentes, **caractérisé en ce qu'**il comprend un dissipateur thermique (7) selon l'une des revendications précédentes intégré dans l'axe d'une durite (5) de circulation d'un flux.

## Patentansprüche

1. Leistungselektroniksystem (1), das ein oder mehrere Leistungselektronikbauelemente (2) beinhaltet, die mindestens teilweise auf einer oder mehreren Leiterplatten (3) implementiert sind, **dadurch gekennzeichnet, dass** die Leiterplatte (3) eine planare kreis- oder torusförmige Form aufweist, die in der Mitte eine kreisförmige Öffnung (4) mit einem Durchmesser D beinhaltet, um mit einem Schlauch (5) zur Zirkulation einer Strömung zur Kühlung von Leistungselektronikbauelementen zusammenzuwirken.

2. Leistungselektroniksystem (1) nach dem vorhergehenden Anspruch, **dadurch gekennzeichnet, dass** die Leiterplatte (3) im Wesentlichen senkrecht zu dem Schlauch (5) zur Zirkulation der Strömung und im Wesentlichen in derselben Achse wie der Schlauch (5) positioniert ist, sodass die Strömung durch die kreisförmige Öffnung (4) der Leiterplatte (3) zirkuliert.

3. Leistungselektroniksystem (1) nach dem vorhergehenden Anspruch, **dadurch gekennzeichnet, dass** der Schlauch (5) zur Zirkulation der Strömung ein Lufteinlassschlauch (5) eines Verbrennungsmotors (M) ist.

4. Leistungselektroniksystem (1) nach dem vorhergehenden Anspruch, **dadurch gekennzeichnet, dass** der Schlauch (5) einen Durchmesser D1 aufweist, der im Wesentlichen größer als oder gleich dem Durchmesser D der kreisförmigen Öffnung (4) der Leiterplatte (3) ist.

5. Leistungselektroniksystem (1) nach einem der vorhergehenden Ansprüche, **dadurch gekennzeichnet, dass** es ein Gehäuse (6) beinhaltet, in dem die Leiterplatte (3) montiert ist.

6. Leistungselektroniksystem (1) nach dem vorhergehenden Anspruch, **dadurch gekennzeichnet, dass** das Gehäuse (6) kreis- oder torusförmig ist und eine mittige Öffnung mit einem Durchmesser D2 beinhaltet, der im Wesentlichen äquivalent zu oder größer als der Durchmesser D der kreisförmigen Öffnung (4) der Leiterplatte (3) ist.

7. Leistungselektroniksystem (1) nach Anspruch 5, **dadurch gekennzeichnet, dass** das Gehäuse (6) Rippen umfasst, die dazu bestimmt sind, die Wärme im Inneren des Gehäuses (6) aufzunehmen und diese an die Strömung des Schlauchs (5) zu übertragen.

8. Leistungselektroniksystem (1) nach einem der Ansprüche 5 bis 7, **dadurch gekennzeichnet, dass** das Gehäuse (6) einen Ventilator umfasst.

9. Leistungselektroniksystem (1) nach einem der Ansprüche 5 bis 8, **dadurch gekennzeichnet, dass** das Gehäuse (6) ein System zur Zirkulation eines Teils der Strömung des Schlauchs (5) im Inneren des Gehäuses (6) beinhaltet.

10. Leistungselektroniksystem (1) nach einem der vorhergehenden Ansprüche, **dadurch gekennzeichnet, dass** es einen Kühlkörper (7) beinhaltet, der mit der Leiterplatte (3) und/oder den Leistungselektronikbauelementen (2) thermisch verbunden ist.

11. Leistungselektroniksystem (1) nach dem vorhergehenden Anspruch, **dadurch gekennzeichnet, dass** der Kühlkörper (7) ein Zylinder mit einem Durchmesser D3 ist, der im Wesentlichen äquivalent zu dem Durchmesser der Leiterplatte (3) ist, und der Kühlkörper (7) eine mittige Öffnung (8) mit einem Durchmesser beinhaltet, der im Wesentlichen äquivalent zu dem Durchmesser D der kreisförmigen Öffnung (4) der Leiterplatte (3) ist, und die mittige Öffnung (8) einen Innenrand (9) beinhaltet.

12. Leistungselektroniksystem (1) nach dem vorhergehenden Anspruch, **dadurch gekennzeichnet, dass** der Kühlkörper (7) Rippen (10) beinhaltet, die kreisförmig an dem Innenrand (9) positioniert sind, und die Rippen (10) von dem Innenrand (9) des Kühlkörpers (7) zu der Mitte des Schlauchs (5) hin konvergieren.

13. Leistungselektroniksystem (1) nach Anspruch 11 oder 12, **dadurch gekennzeichnet, dass** der Zylinder Zähne (11) beinhaltet.

14. Leistungselektroniksystem (1) nach Anspruch 10, **dadurch gekennzeichnet, dass** der Kühlkörper (7) ein Zylinder (12) mit einem Außendurchmesser D4 ist, der eine mittige Öffnung (13) mit einem Durchmesser, der im Wesentlichen äquivalent zu dem Durchmesser D der kreisförmigen Öffnung (4) der Leiterplatte (3) ist, beinhaltet, und die mittige Öffnung (13) einen Innenrand (14) beinhaltet.

15. Leistungselektroniksystem (1) nach dem vorhergehenden Anspruch, **dadurch gekennzeichnet, dass** die Leistungselektronikbauelemente (2) mindestens teilweise auf dem Zylinder (12) implementiert sind.

16. Leistungselektroniksystem (1) nach dem vorhergehenden Anspruch, **dadurch gekennzeichnet, dass** der Kühlkörper (7) Rippen (10) beinhaltet, die kreisförmig an dem Innenrand (14) positioniert sind, und die Rippen (10) von dem Innenrand (14) des Kühlkörpers (7) zu der Mitte des Schlauchs (5) hin konvergieren.

17. Leistungselektroniksystem (1) nach einem der vorhergehenden Ansprüche, **dadurch gekennzeichnet, dass** es eine elektrische Maschine (ME) speist.

18. Leistungselektroniksystem (1) nach dem vorhergehenden Anspruch, **dadurch gekennzeichnet, dass** die elektrische Maschine (ME) einen Kompressor (C) antreibt.

19. Leistungselektroniksystem (1) nach Anspruch 17, **dadurch gekennzeichnet, dass** die elektrische Maschine (ME) eine Turbine (T) eines Turbokompressors (Tc) antreibt.

20. Leistungselektroniksystem (1) nach einem der Ansprüche 18 oder 19, **dadurch gekennzeichnet, dass** die elektrische Maschine (ME) stromaufwärts des Kompressors (C) oder der Turbine (T) des Turbokompressors (Tc) angeordnet ist.

21. Leistungselektroniksystem (1) nach Anspruch 17, **dadurch gekennzeichnet, dass** die elektrische Maschine (ME) auf einer Welle (21) angeordnet ist, die den Kompressor (C) des Turbokompressors (Tc) mit einer Turbine (T) des Turbokompressors (Tc) verbindet.

22. Vorrichtung zur Kühlung eines Leistungselektroniksystems (1) nach einem der vorhergehenden Ansprüche, **dadurch gekennzeichnet, dass** sie einen Kühlkörper (7) nach einem der vorhergehenden Ansprüche beinhaltet, der in die Achse eines Schlauchs (5) zur Zirkulation einer Strömung integriert ist.

## Claims

1. Power electronic system (1) comprising one or more power electronic components (2) implemented at least partly on one or more circuit boards (3), **characterized in that** said circuit board (3) is planar and circular or toroidal in shape, the centre of which comprises a circular opening (4) of diameter D for cooperating with a hose (5) for circulating a flow for cooling power electronic components.

2. Power electronic system (1) according to the preceding claim, **characterized in that** the circuit board (3) is positioned substantially orthogonally to the hose (5) for circulating the flow and substantially in the same axis as said hose (5) such that said flow circulates through the circular opening (4) in the circuit board (3) .

3. Power electronic system (1) according to the preceding claim, **characterized in that** said hose (5) for circulating the flow is an air intake hose (5) for an internal combustion engine (M).

4. Power electronic system (1) according to the preceding claim, **characterized in that** the diameter D1 of the hose (5) is substantially larger than or equal to the diameter D of the circular opening (4) in the circuit board (3).

5. Power electronic system (1) according to one of the preceding claims, **characterized in that** it comprises a mechanical housing (6) in which the circuit board (3) is mounted.

6. Power electronic system (1) according to the preceding claim, **characterized in that** the mechanical housing (6) is circular or toroidal in shape and comprises a central opening of diameter D2 that is substantially equivalent to or larger than the diameter D of the circular opening (4) in the circuit board (3).

7. Power electronic system (1) according to Claim 5, **characterized in that** the mechanical housing (6) incorporates fins for capturing the heat inside the mechanical housing (6) and transferring it to the flow from the hose (5) .

8. Power electronic system (1) according to one of Claims 5 to 7, **characterized in that** the mechanical housing (6) incorporates a fan.

9. Power electronic system (1) according to one of Claims 5 to 8, **characterized in that** the mechanical housing (6) comprises a system for circulating a portion of the flow from the hose (5) inside said mechanical housing (6).

10. Power electronic system (1) according to one of the preceding claims, **characterized in that** it comprises a heat sink (7) that is connected thermally to the circuit board (3) and/or to the power electronic components (2).

11. Power electronic system (1) according to the preceding claim, **characterized in that** the heat sink (7) is a cylinder of diameter D3 that is substantially equivalent to the diameter of the circuit board (3) and said heat sink (7) comprises a central opening (8), the diameter of which is substantially equivalent to the diameter D of the circular opening (4) in the circuit board (3), and the central opening (8) comprises an inner edge (9) .

12. Power electronic system (1) according to the preceding claim, **characterized in that** the heat sink (7) comprises fins (10) that are positioned circularly around the inner edge (9) and the fins (10) converge from the inner edge (9) of the heat sink (7) towards the centre of the hose (5).

13. Power electronic system (1) according to Claim 11 or 12, **characterized in that** the cylinder comprises teeth (11) .

14. Power electronic system (1) according to Claim 10, **characterized in that** the heat sink (7) is a cylinder (12) of outer diameter D4 which comprises a central opening (13), the diameter of which is substantially equivalent to the diameter D of the circular opening (4) in the circuit board (3), and the central opening (13) comprises an inner edge (14).

15. Power electronic system (1) according to the preceding claim, **characterized in that** the power electronic components (2) are implemented at least partly on the cylinder (12).

16. Power electronic system (1) according to the preceding claim, **characterized in that** the heat sink (7) comprises fins (10) that are positioned circularly around the inner edge (14) and the fins (10) converge from the inner edge (14) of the heat sink (7) towards the centre of the hose (5).

17. Power electronic system (1) according to one of the preceding claims, **characterized in that** it supplies an electric machine (ME) with power.

18. Power electronic system (1) according to the preceding claim, **characterized in that** said electric machine (ME) drives a compressor (C).

19. Power electronic system (1) according to Claim 17, **characterized in that** said electric machine (ME) drives a turbine (T) of a turbocharger (Tc).

20. Power electronic system (1) according to either of Claims 18 and 19, **characterized in that** said electric machine (ME) is arranged upstream of said compressor (C) or of the turbine (T) of said turbocharger (Tc).

21. Power electronic system (1) according to Claim 17, **characterized in that** said electric machine (ME) is arranged on a shaft (21) which connects the compressor (C) of said turbocharger (Tc) to a turbine (T) of said turbocharger (Tc).

22. Device for cooling a power electronic system (1) according to one of the preceding claims, **characterized in that** it comprises a heat sink (7) according to one of the preceding claims incorporated in the axis of a hose (5) for circulating a flow.
